Europäisches Patentamt

European Patent Office

Office européen des brevets

(11) Publication number: **0 468 553 A2**

# EUROPEAN PATENT APPLICATION

(21) Application number: **91201372.9**

(22) Date of filing: **04.06.91**

(51) Int. Cl.⁵: **G06F 15/20**, G01R 31/28, G06F 11/22

(30) Priority: **08.06.90 US 535079**

(43) Date of publication of application:
**29.01.92 Bulletin 92/05**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Schippers, Alef**
**c/o INT. OCTROOIBUREAU B.V., Prof.**
**Holstlaan 6**
**NL-5656 AA Eindhoven(NL)**

(74) Representative: **Zwaan, Andries Willem et al**
**INTERNATIONAAL OCTROOIBUREAU B.V.**
**Prof. Holstlaan 6**
**NL-5656 AA Eindhoven(NL)**

(54) Instrumentation system and instrumentation devices adapted for use in such a system.

(57) An instrumentation system is disclosed comprising a central processor and instrumentation devices for executing an instrumentation program for a target system such as a unit under test. The instrumentation devices comprise a sequence memory for storing sequences of commands of the instrumentation program to be executed. The central processor downloads the sequences into the sequence memories. Corresponding steps in the sequences for the instrumentation devices are executed autonomously and synchronously, i.e. without intervenience of the central processor. The instrumentation devices in the instrumentation system comprise a data memory, which can be accessed by the central processor asynchronously, i.e. during autonomous execution of an instrumentation program or thereafter.

FIG.1

## FIELD OF THE INVENTION

The invention relates to an instrumentation system comprising a central processor, which is coupled via at least one communication bus to a plurality of instrumentation devices, and which comprises an instrumentation program to be executed by the instrumentation devices, the instrumentation devices to be coupled to a target unit under programmed control of the instrumentation program.

The invention further relates to an instrumentation device adapted for use in such a system.

The instrumentation devices can be stimulus instruments, measuring instruments and signal routing devices for routing various signals in the instrumentation system.

Such an instrumentation system can be used for automatic functional and diagnostic testing of units under test as target units, such as printed circuit boards, circuits in audio or TV apparatus, or a data-acquisition system for collecting measurement data from various sources, or a control system as a target unit.

## BACKGROUND OF THE INVENTION

Such an instrumentation system as a test system is known from the US Patent No. 4,402,055. In said test system a central processor is coupled to a number of instruments and to a signal routing device via a number of IEEE 488 buses, and a unit under test is coupled to the signal routing device. The central processor executes a test program as an instrumentation program. Stimulus instruments such as generators to supply voltage, current or frequency input signals and measuring instruments such as voltmeters and digitizers are coupled to the unit under test by means of a signal routing device under programmed control of the central processor program.

In such a system various synchronization and speed problems might occur. It might be required that various instruments having an IEEE 488 or GPIB interface e.g. should react simultaneously, e.g. a digital oscilloscope measures a step response on a signal generator step signal supplied to the unit under test. First adjustment commands are supplied to the oscilloscope and to the signal generator and then a so-called broadcast command is given such as a Group Execute Trigger (triggers instrument activity simultaneously). Uncertainty in reaction time of the various instruments might cause wrong measuring results, in the example given the oscilloscope could react too late and overlook the unit under test response on the rising edge of the step signal. Also synchronization in time might be required, e.g. a signal routing device is not allowed to switch signals during a voltage measurement being carried out by a voltmeter. A further complication arises when the test system comprises several signal routing devices, giving rise to a complex switching pattern. Furthermore there is a lot of time consuming central processing activity. The processor supplies a selection command to the signal routing device, checks whether the signal routing device is ready by accessing a signal routing device status via the communication bus or by waiting until a timer has lapsed (worst case), and so on. In other words, a lot of time is spent on bus access (e.g. 1 ms per bus access), giving rise to a reduced system throughput.

## SUMMARY OF THE INVENTION

It is an object of present invention to overcome the drawbacks given and further to provide an efficient and flexible instrumentation system, such as an automatic test system, a data acquisition system, or a control system.

A instrumentation system according to present invention is characterized in that the instrumentation devices comprise a memory for receiving sequences of commands from the instrumentation program, which sequences are downloaded by the central processor, and in that the instrumentation devices are coupled to each other via a synchronization bus and comprise step executing means for autonomously and synchronously executing steps of the downloaded sequences under control of the synchronization bus, wherein the step executing means are arranged such that first a step is executed and thereafter the system is prepared for executing a next successive step.

In such an instrumentation system, in which the sequence steps include instrument setup commands, instrument activation commands and update commands for updating instrument setup inter alia , the central processor is released from its controlling task once the sequences of commands have been downloaded, and the central processor can be used for general purposes, for downloading commands to other instrumentation systems, and so on. Other advantages are an increased system throughput as every step of the downloaded sequence is executed immediately after a previous step, and an optimum synchronization between steps because of the fact that every participating instrument or signal routing device knows the action to be carried out in advance, i.e. before a next step is initiated. In particular embodiments the instrumentation system may not comprise signal routing devices, e.g. in a data-acquisition system. The particular configuration depends on the use of the system.

A step may also be a no-operation and in an advantageous embodiment of the instrumentation system the step memory contains a count and a command area in an instrument address location, then. The count represents the number of no-operation steps to be skipped for the instrument. The latter saves memory space.

In an embodiment of a instrumentation system according to present invention the synchronization bus comprises a step line for synchronously initiating execution of a step of the instrumentation program and comprises a ready line or uses the step line for signalling that the instrumentation devices are ready to execute a next successive step. The step line initiates a step of the instrumentation program for the instrumentation devices, e.g. by means of a high-to-low transition, and remains low for a predetermined time during which the instrumentation devices should acknowledge by taking over this transition. Then the present step is carried out, i.e. the instrumentation devices execute the respective commands in the present step. In the embodiment in which the step memory contains a no-operation count the count is counted down, e.g. by a presetable down-counter triggered by the step line transition. The instrumentation devices should all signal ready before a next step is allowed to be carried out. To ensure proper ready signalling the various instrumentation devices might be coupled to the ready line via a wired-AND (open collector outputs).

In a further embodiment of an instrumentation system according to present invention at least one of the instrumentation devices comprises means for generating a deferred ready signal for relatively slow steps such that the other devices may proceed without delay. An instrumentation device carrying out a slow measurement such as a temperature measurement would reduce system throughput. A particular step memory location of such an instrumentation device could contain a noready command followed by a number of no-operation commands in successive memory locations, and a signal ready command in the next successive location. On the noready command the instrumentation device executes the relatively slow step in parallel with other steps of other devices, but the slow step is not involved in determining ready for the parallel steps being executed for a while. On the signal ready command in said next successive location the slow device also determines whether the present step is ready, i.e. may have finished the previous slow step or may delay the process.

In an embodiment of an instrumentation system according to present invention the synchronization bus comprises at least one further step line for achieving parallel execution of subsequences in order to carry out several instrumentation processes at a time. E.g. in a TV set the rf-part and audio part can thus be parallel but separately tested. Then several groups of instrumentation devices react on different step lines.

In a further embodiment of an instrumentation system according to present invention the synchronization bus further comprises a start line for initiating or resetting a sequence or comprises a plurality of start lines for initiating or resetting a number of subsequences. After downloading the sequence can be initiated thus releasing the central processor. Also an instrumentation process could be reinitiated, e.g. when the instrumentation process is a test for testing a unit under test and a next unit under test is to be tested. It is to be noticed that steps may be executed only after the start action is finished. A start could be considered a zeroth step without an actual step being executed, i.e. a start action should be followed by signalling ready, or, a start prepares the system for executing the first step. A start may originate from the regulator device, the central processor, or any other system component, e.g. in a test system a transport belt transporting units under test may generate a start via a $\mu$-switch after a unit under test has been connected to the system.

In an embodiment of an instrumentation system according to present invention the instrumentation devices are separate devices and the instrumentation system further comprises a regulator device coupled with the synchronization bus for generating step control signals and for receiving ready signals or the central processor acts as a regulator. In this so-called rack-and-stack embodiment in which various devices are coupled to the central processor by means of a GPIB-bus or V24-bus a separate regulator controls the autonomous instrumentation process, or, less advantageously, the central processor acts as a regulator. Each device could have its own ready line, step line or any combination thereof.

In an embodiment of an instrumentation system according to present invention the instrumentation devices form a closed system and one of the instrumentation devices acts as a regulator device for generating step control signals and for receiving ready signals. In a closed system embodiment the instrumentation devices are closely coupled to each other. A communication bus such as a GPIB-bus and a synchronization bus couples the devices, wherein each device comprises a GPIB interface coupled to the central processor and a device processor and a trigger line interface to couple the device processor to the synchronization bus.

In a further embodiment of an instrumentation system according to present invention synchronization on the synchronization bus is implemented using a semi-sync-protocol as defined for a VXI-bus, the regulator being a source and the other devices being acceptors in the semi-sync-protocol.

Said trigger line interfaces support a VXI-bus semi-sync-protocol, and can select a VXI triggerline.

In an embodiment of an instrumentation system according to present invention the synchronization bus comprises at least one additional line for indicating a special status of an instrumentation device in response whereupon the other instrumentation devices may be initiated to proceed with a different subsequence. In case of one additional line it may be signalled whether to proceed with the present sequence or to proceed with a subsequence, e.g. in dependence to a test in an instrumentation device whether a measurement value falls within a predetermined range. With a further additional line, e.g. a subsequence selection can be carried out. A first combination of bits on the two lines can indicate to proceed with the present sequence, a second combination can indicate to proceed with a first subsequence and a third combination can indicate to proceed with a second subsequence, in respective cases a measurement value is acceptable, is too large or is too small. Also the additional lines may be used for initiating and controlling adjustment loops for particular instrumentation devices. During adjustment a device is decoupled from the instrumentation process. Then, a first combination of bits on the above two lines indicates that the adjustment is finished, and a second and a third combination indicate adjustement, e.g. stepping down or up of an adjustment potentiometer.

In a further embodiment of an instrumentation system according to present invention the instrumention devices comprise a data memory for storing measuring results and status information inter alia and the central processor asynchronously reads the data memory or reads the data memory on request of the instrumentation devices. The central processor can access the measuring results any time or on request, depending on the measurement situation, e.g. in a continuous test asynchronous reading out could be meaningful and in a single test reading out on request. In a closed system said VXI-bus semi-sync-protocol can be used for implementing sysnchronization on the synchronization bus. In such semi-sync-protocol wherein a single line is used as a step and ready line, the step line corresponding to the source and the ready line corresponding to a number of acceptors in the protocol, the acceptors should acknowledge within a realtively short time, say 20 ns. This short time might cause problems in case of relatively long propagation delays in the system, e.g. in a rack-and-stack system. Another protocol in VXI would be an async protocol wherein two lines are defined, for one source and one acceptor, but therein an acknowledge time on the second line with respect to a step on the first line is not defined. According to the invention such an async protocol is modified in that the second line supports a plurality of acceptors, in that the acceptors acknowledge within a predetermined maximum time to a step on the first line, and in that the acceptors signal ready after a minimum time longer than the maximum time. When such a protocol is used in an instrumentation system according to present invention with relatively long propagation delay times several instrumentation devices may acknowledge within the maximum time, e.g. 1 $\mu$s, without the source recognizing acceptor pulses too early. The second line is wired-ANDed with the acceptors in case of an instrumentation system. It should be noticed that the protocol according to the invention, a so-called semi-async-protocol, may have general application, i.e. is not restricted to use in instrumentation systems.

BRIEF DESCRIPTION OF THE DRAWINGS

The features and advantages of the instrumentation system according to present invention will be more clearly apparant from the following detailed description, in conjunction with the accompanying drawing, wherein

Fig. 1 is a block diagram illustrating the interface and bus organization of the instrumentation system according to the invention,

Fig. 2 shows an instrument configuration for illustrating a sequence operation according to the invention,

Fig. 3 shows a downloaded sequence for two instruments and one signal routing device for further illustrating the sequence operation according to the invention,

Fig. 4 shows an advantageous embodiment for handling no-operation in an instrument or signal routing device,

Fig. 5 shows a timing diagram for step/ready line implementation according to the invention.

Fig. 6A shows a synchronization bus interface implementing a semi-async-protocol according to the invention, and

Fig. 6B shows semi-async-protocol signals according to the invention as a function of time.

DESCRIPTION OF EMBODIMENTS

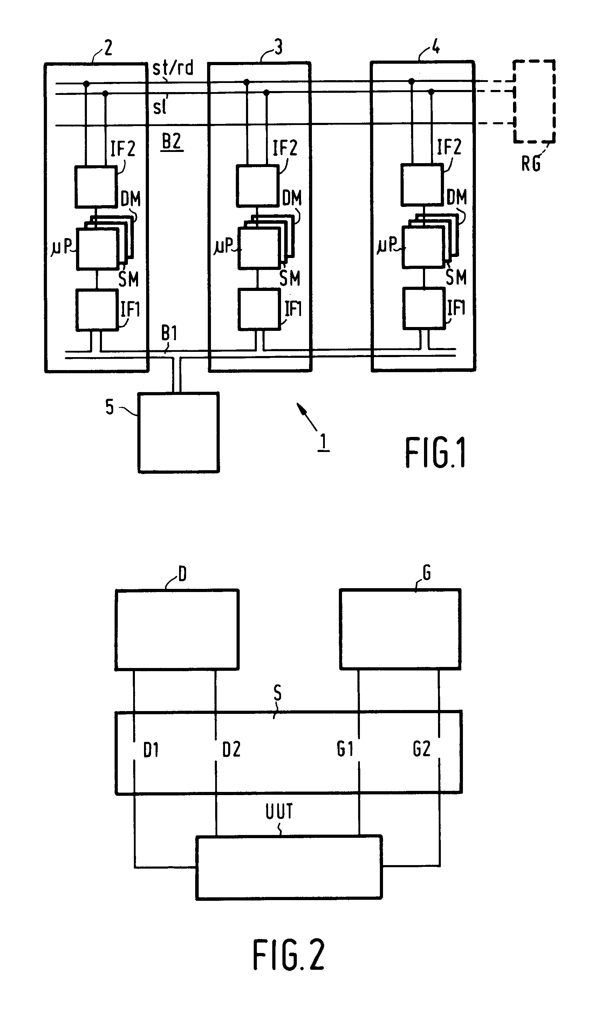

In figure 1 a block diagram of a instrumentation system 1 is shown, illustrating the interface and bus organization of the instrumentation system 1. The instruments 2, 3 and the signal routing device 4 are coupled to each other by means of a communication bus B1 which can be any suitable bus such as a GPIB-bus or IEEE 488-bus (see e.g. ANSI/IEEE std 488.1-1987), VME-bus, VXI-bus and so on. In the embodiment given the communication bus is a GPIB-bus, well known in the art. The GPIB-bus will not be described in detail. The GPIB-bus is also coupled to a central processor 5 comprising suitable programming means for developing an instrumentation program for testing a unit under test, for collecting data from a data-acquisition target, or for inputting and outputting data to a control system. The instruments 2, 3 and further instruments and the signal routing device 4 and further signal routing devices are also coupled to each other by means of a synchronization bus B2 comprising a step line st for triggering stepping through downloaded sequences, a ready line rd for confirming that a step has been completed and a start line sl for starting or restarting a downloaded sequence. In a preferred embodiment of a instrumentation system 1 according to present invention two TTL trigger lines are used from a VXI-bus specification which defines 8 TTL (open collector) and 6 ECL trigger lines, in which each TTL trigger line utilizes the VXI-bus semi sync protocol. The semi-sync-protocol is a single source, multi acceptor protocol. For further details of the well known VXI-bus specification see e.g. "Exploring VXIbus Systems and Instrumentation", K. Chipperfield, IEEE 1989. According to the invention one of the VXI-bus TTL trigger lines is used as step/ready line st/rd and another TTL trigger line is used as start line sl. In a closed system once the instrumentation program has been downloaded one of the instrumentation devices acts as a regulator being a source in the VXI-bus semi-sync-protocol, and the central processor 5 is released for other tasks. By asserting a trigger on the start line sl, e.g. a high-to-low transition, the regulator activates the execution of a sequence of preprogrammed and downloaded commands causing the first step of the sequence to be executed when the step line st is triggered by the regulator. The other devices are acceptors in the VXI-bus protocol, i.e. devices which acknowledge the trigger on the step line. An acceptor device must release the start line sl when it is ready to accept the first trigger on the step line st, i.e. is ready to execute the first preprogrammed command. After a process has been started the steps are successively executed. First the regulator or source asserts a trigger on the step line st. Second all other devices or acceptors also assert the trigger within a given time on the step line st (40 ns for a VXI semi-sync-protocol). Third, the acceptor devices release the trigger when they have executed their preprogrammed actions and are prepared for executing a next successive step. Finally, the regulator recognizes acknowledge completion when the regulator and all acceptor devices have released the trigger on the step line st. A minimum time following the completion of a previous acknowledge cycle, the regulator reasserts the trigger on the step line st to initiate the execution of the next step. So, in the semi-sync protocol all devices react on a single trigger line and execute their preprogrammed actions. When a device has no action to perform (no-operation), it releases the step line st immediately. Since triggering is done in hardware system througput is improved. When an instrument is a measuring instrument such as a digital oscilloscope or voltmeter it comprises a data memory DM in which measurement results are stored. The central processor 5 can asynchronously read the data memory DM, i.e. without interfering with the execution of the commands stored in a sequence memory SM. The instruments and signal routing devices also comprise a $\mu$-processor $\mu$p, so a measuring instrument can check if a measurement falls within a given range. The measurement device can hold the step line st low when the measuring result is incorrect and can inform the other devices accordingly via an additional VXI-bus trigger line, so that the other devices might initialize an alternative sequence without interference of the central processor 5. The sequence memory SM may contain more than one process each process being identified by a label. Then, the device does not have to be re-programmed when another process is to be executed, but in the case of a single step line only one test process may be enabled at a time. Further step lines can be implemented as VXI-bus trigger lines, allowing more than one test process to be active in a single system at a time, i.e. measurements can be carried out in parallel then, such as parallel testing of the rf-part and audio part of a TV set. Then, instrumentation devices should be uniquely allocated to a single process. The processes can be coupled through a common start line sl. The start line sl also allows for an asynchronous restart when during the sequence a defective unit under test is found. E.g. when testing TV sets and it is recognized that a TV set fails one of the measuring devices can generate a start which can result in placing another TV set as a unit under test and restarting the sequence for this TV set. The distribution of commands during downloading may also take place via other bus structures than a GPIB bus, e.g. the central processor is coupled to one of the instrumentation devices, but distribution to other devices takes place via a backplane-bus. The instrumentation devices further comprise interfaces such as an interface IF1 for interfacing the GPIB-bus or another bus to the microprocessors $\mu$P or an interface IF2 e.g. for implementing the VXI-bus trigger lines. In case the interface IF1 interfaces a GPIB-bus IF1 can be a standard GPIB interface such as an INTEL 8291. It could be demanded than an instrument supports all 8 VXI-bus TTL trigger lines. Then the interface IF2 comprises a multiplexer for software selectable coupling trigger lines to the instrument. The interface structure will not be described in detail for all protocols as the structure depends on the specific implementation of buses and protocols chosen. The interface structure will be described further for the semi-async-protocol according to the invention. In a rack-and-stack embodiment of the instrumentation system the various independent instruments comprise a sequence memory in which the sequence can be downloaded and a data memory for storing measurement data if appropriate, and step, ready and start lines coupled to a separate regulator RG which controls the instrumentation system after downloading of the commands by the central processor 5. In that case the ready lines are wired-AND lines (open collector lines). For a rack-and-stack embodiment a semi-async-protocol can be implemented on separate step and ready lines as will be described further. It should be noticed that for clarity all further interconnections between instruments have been left out in figure 1. Such interconnection will be illustrated in figure 2. It should further be noticed that only the parts of the instruments are shown relevant for the invention.

Figure 2 shows an instrument configuration for illustrating a sequence operation. In the illustrative process a digitizer D such as a digital oscilloscope as a measuring instrument can be coupled to a unit under test UUT via a signal routing device S. Further, a generator G can be coupled to the unit under test UUT via the signal routing device S as a stimulus instrument. The signal routing device comprises switches D1 and D1, and G1 and G2 for respective the digitizer D and generator G to the unit under test UUT.

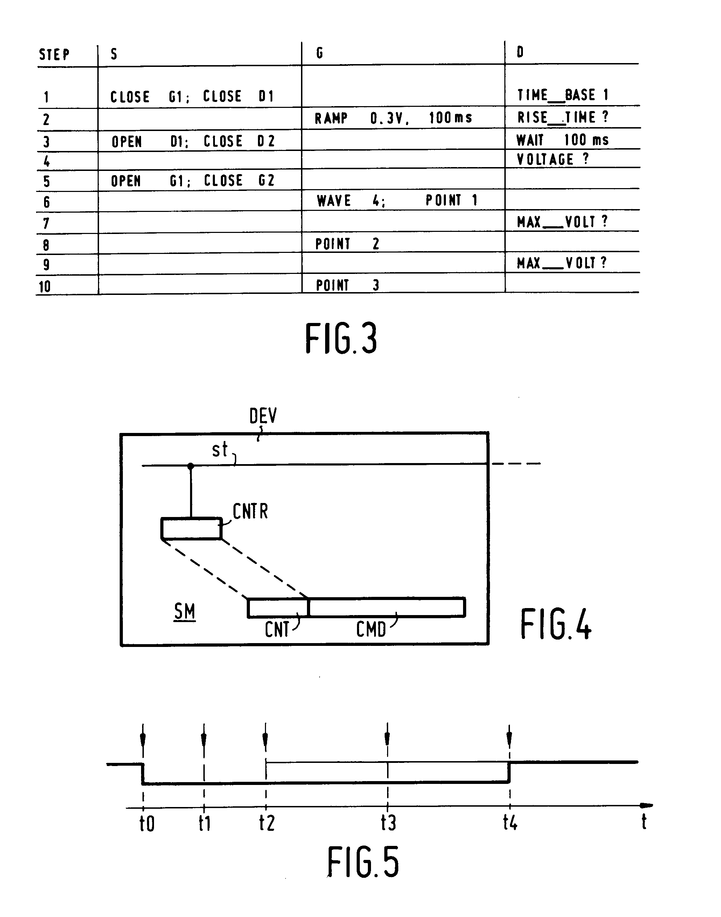

Figure 3 shows a downloaded sequence for the two instruments D and G and for the signal routing device S. For illustration of the operation of the instrumentation system 1 according to the invention 10 steps are shown. The steps are stored in sequence memories SM (see figure 1) in corresponding memory locations. For the signal routing device S the steps are:

step 1: CLOSE G1; CLOSE D1
step 2: NOP
step 3: OPEN D1; CLOSE D2
step 4: NOP
step 5: OPEN G1; CLOSE G2
step 6: NOP
step 7: NOP
step 8: NOP
step 9: NOP
step 10: NOP
For the generator G the steps are:
step 1: NOP
step 2: RAMP 0.3V, 100 ms
step 3: NOP
step 4: NOP

step 5: NOP
step 6: WAVE 4; POINT 1
step 7: NOP
step 8: POINT 2
step 9: NOP
step 10: POINT 3
For the digitizer the steps are:
step 1: TIME__BASE 1
step 2: RISE TIME?
step 3: WAIT 100 ms
step 4: VOLTAGE?
step 5: NOP
step 6: NOP
step 7: MAX__VOLT?
step 8: NOP
step 9: MAX__VOLT?
step 10: NOP
All corresponding steps are executed simultaneously as described in foregoing. Commands can be in IEEE 488.2 format for an IEEE 488 bus or a VXI-bus. Programming of the sequence in the controller can be done in an appropriate high level language such as BASIC, PASCAL and so on. The commands for the signal routing device are self-explaining and imply open and closing of switches. The generator G is setup to a particular waveform and the waveform is initiated. The digitizer D is setup and various measuring quantities are measured such as a signal rise time in response to a ramp signal and a voltage of the ramp response after 100 ms inter alia .

A process is defined in the devices in several phases. First process parameters (process label, step line and start line) are defined for all devices with a DEFINE:BEGIN command, and the device enters the process programming mode. Then the DEFINE:START command can be used to define the start settings, which are the settings which will be used when the start line is activated. Next the consecutive steps in the sequence can be defined, with the DEFINE:STEP command for programming an individual step in a single device by selecting a step number and programming the commands for that step, with a DEFINE:CONT command for defining only the active steps in a single device, in which case the number of steps to be skipped before the next step to be executed should be given, and the DEFINE:NAMED command together with the DEFINE:NEXT command for programming all the devices at the same time. In the latter case a logical device name is preceding the actual commands. The device will recognize its logical name, and only store the commands for this device. After the steps of the sequence have been programmed the definition is closed with a DEFINE:END command. In order to define an instrumentation program more easily an instrumentation sequence program is developed, allowing the user to fill in a table, which is organized in such a way that the rows are corresponding to the steps and the columns are corresponding to the devices involved (see figure 3). Further during processing status reporting messages and queries can be executed.

Figure 4 shows an advantageous embodiment for handling no-operations in an instrumentation device. In a device DEV the steps of a sequence are stored as two items, a counter value CNT which contains the number of step pulses to be ignored (no-operations or NOP's) and the commands CMD to be executed in the step. The counter value is loaded in a presetable down counter CNTR triggered by the step line st. This has the effect that a number of steps as given by the counter value is skipped for the particular device with the advantage that for NOP's no memory locations are occupied in the sequence memory SM of the device. Furthermore NOP's are processed faster because of the hardware implementation of counting down.

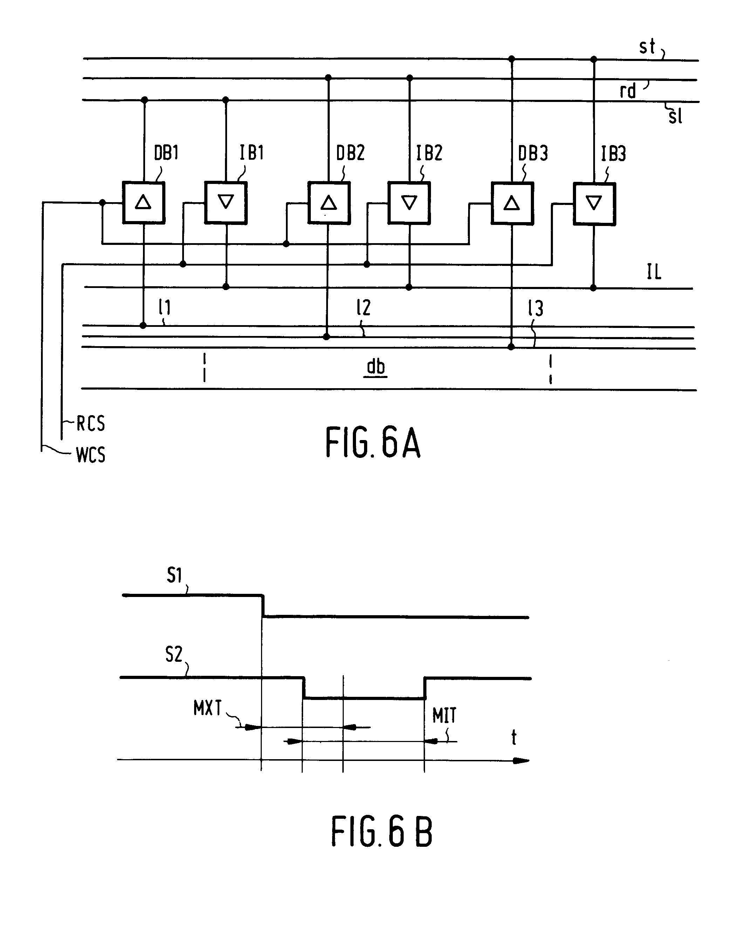

Figure 5 shows a timing diagram for a step/ready line implementation in a VXI semi-sync-protocol as a function of time t. Various instants, t0, t1, t2, t3, and t4 are shown. At t = t0 the regulator asserts a high-to-low transition (trigger) for a minimum of time. At t = t1 all acceptor devices stretch the low within a given time. At t = t2 the fastest acceptor device unasserts the low when it is ready, at t = t3 the next device unasserts low and at t = t4 the slowest device unasserts low. Then the instrumentation system is prepared for the next successive step.

Figure 6A shows a synchronisation bus interface IF2 implementing a semi-async-protocol according to the invention. A step line st, a ready line rd and a start line sl are coupled with an interrupt line IL via buffers IB1, IB2, and IB3. The interrupt line IL and a databus db form part of the device microprocessor μP (see figure 1). The step line st, the ready line rd, and the start line sl are further coupled to separate lines 11, 12, and 13 of the databus db via buffers DB1, DB2, and DB3. The buffers IB1, IB2, and IB3 are latched by the read/chip-select RCS of the microprocessor μP after an interrupt has occurred, and the buffers DB1, DB2, and DB3 are latched by the write/chip-select of the microprocessor μP. An interrupt causes an interrupt service routine in the μP to be activated reading the buffers IB1, IB2, and IB3 for checking the status of the lines, the interrupt line is reset. The regulator (instrumentation device) reacts accordingly. See further the description of the invention. Via the buffers DB1, DB2, and DB3 the microprocessor μP can activate the various synchronization lines. The above interface IF2, together with the microprocessor μP in the regulator implement the semi-async-protocol according to the invention as described before.

Figure 6B shows semi-async-protocol signals as a function of the time t. A first signal s1 appears on the step line st under control of the microprocessor μP in the regulator (one source). On a high-to-low transition of the signal st on the step line st the other devices (a number of acceptors) should acknowledge within a maximum time MXT. After acknowledgement, a minimum time MIT before signalling ready on the ready line rd should be longer than the maximum time MXT. This accomplishes that all instrumentation devices acknowledge before ready signalling takes place, thus preventing the source of recognizing different acceptor pulses, leading to possible wrong results. The maximum time MXT can be 1 μs typically. The ready line rd is wire-ANDed within the various instrumentation devices. It should be noticed that the electrical properties of IEEE 488.1 can be used advantageously in a rack-and-stack embodiment e.g.

It should be noticed that within the scope of present invention numerous variants for different types of buses and instrumentation devices may be implemented. Also devices not supporting or partially supporting sequence stepping according to the invention can be involved in the instrumentation system. Then different strategies could be undertaken, e.g. the instrumentation system could operate as if all devices are not supporting process programming, or the system operates according to process programming for devices supporting process programming and interrupts the central processor for executing a command for a device not supporting process programming. Although the starting and stepping is described as being asynchronous, starting and stepping information can also be supplied synchronously to the synchronization bus by means of a time base in the regulator, e.g. every second a step could be generated. The latter embodiment may cause step synchronization problems however. Also, the central processor may hold the process for a predetermined time. For continous testing e.g. the responses could be stored in a wrap-around-mode, i.e. only the most recent responses could be stored in case the data memory would become full.

## Claims

1. An instrumentation system comprising a central processor, which is coupled via at least one communication bus to a plurality of instrumentation devices, and which comprises an instrumentation program to be executed by the instrumentation devices, the instrumentation devices to be coupled to a target unit under programmed control of the instrumentation program, characterized in that the instrumentation devices comprise a memory for receiving sequences of commands from the instrumentation program, which sequences are downloaded by the central processor, and in that the instrumentation devices are coupled to each other via a synchronization bus and comprise step executing means for autonomously and synchronously executing steps of the downloaded sequences under control of the synchronization bus, wherein the step executing means are arranged such that first a step is executed and thereafter the system is prepared for executing a next successive step.

2. An instrumentation system in accordance with claim 1 wherein a step may comprise a no-operation for an instrumentation device.

3. An instrumentation system in accordance with claim 1 or 2 wherein the synchronization bus comprises a step line for synchronously initiating execution of a step of the instrumentation program and comprises a ready line or uses the step line for signalling that the instrumentation devices are ready to execute a next successive step.

4. An instrumentation system in accordance with claim 3 wherein at least one of the instrumentation devices comprises means for generating a deferred ready signal for relatively slow steps such that the other devices may proceed without delay.

5. An instrumentation system in accordance with claim 3 wherein the synchronization bus comprises at least one further step line for achieving parallel execution of subsequences in order to carry out several instrumentation processes at a time.

6. An instrumentation system in accordance with any of the preceding claims wherein the synchronization bus further comprises a start line for initiating or resetting a sequence or comprises a plurality of start lines for initiating or resetting a number of subsequences.

7. An instrumentation system in accordance with any of the preceding claims wherein the instrumentation devices are separate devices and the instrumentation system further comprises a regulator device coupled with the synchronization bus for generating step control signals and for receiving ready signals or the central processor acts as a regulator.

8. An instrumentation system in accordance with any of the claims 1 through 6 wherein the instrumentation devices form a closed system and one of the instrumentation devices acts as a regulator device for generating step control signals and for receiving ready signals.

9. An instrumentation system in accordance with claim 8 wherein synchronization on the synchronization bus is implemented using a semi-sync-protocol as defined for a VXI-bus, the regulator being a source and the other devices being acceptors in the semi-sync-protocol.

10. An instrumentation system in accordance with any of the preceding claims wherein the synchronization bus comprises at least one additional line for indicating a special status of an instrumentation device in response whereupon the other instrumentation devices may be initiated to proceed with a different subsequence.

11. An instrumentation system in accordance with any of the preceding claims wherein the instrumentation devices comprise a data memory for storing measuring results and status information inter alia and the central processor asynchronously reads the data memory or reads the data memory on request of the instrumentation devices.

12. An instrumentation device adapted for use in an instrumentation system in accordance with any of the preceding claims.

13. A synchronization bus protocol for a synchronization bus for synchronizing devices comprising a first line as a source and a second line as an acceptor, characterized in that the second line supports a plurality of acceptors, in that the acceptors acknowledge within a predetermined maximum time to a step on the first line, and in that the acceptors signal ready after a minimum time longer than the maximum time.

FIG.1

FIG.2

| STEP | S | G | D |
|---|---|---|---|
| 1 | CLOSE G1; CLOSE D1 | | TIME__BASE 1 |
| 2 | | RAMP 0.3V, 100ms | RISE__TIME ? |
| 3 | OPEN D1; CLOSE D2 | | WAIT 100 ms |
| 4 | | | VOLTAGE ? |
| 5 | OPEN G1; CLOSE G2 | | |
| 6 | | WAVE 4; POINT 1 | |
| 7 | | | MAX___VOLT ? |
| 8 | | POINT 2 | |
| 9 | | | MAX___VOLT ? |
| 10 | | POINT 3 | |

## FIG.3

FIG.4

FIG.5

FIG. 6A

FIG. 6 B